# FASCICULE DE BREVET EUROPEEN

(11) **EP 2 159 922 B1**
(45) Date de publication et mention de la délivrance du brevet: **20.07.2011**
(21) Numéro de dépôt: 09168629.5
(22) Date de dépôt: 25.08.2009
(51) Int. Cl.: H04B 1/44, H03H 11/36

(54) **Duplexeur actif hyperfréquence commandé**
Gesteuerter aktiver Mikrowellen-Duplexer
Controlled active microwave duplexer

(30) Priorité: 29.08.2008 FR 0804762
(43) Date de publication de la demande: 03.03.2010
(73) Titulaire: Thales, 92200 Neuilly Sur Seine (FR)
(72) Inventeur: Plaze, Jean-Philippe, 78390, BOIS D'ARCY (FR); Dueme, Philippe, 91400, ORSAY (FR); Mallet-Guy, Benoît, 75015, PARIS (FR)
(74) Mandataire: Lucas, Laurent Jacques

(56) Documents cités:
- FR-A- 2 895 150
- US-A- 3 088 105
- US-A- 6 066 993
- BAHL I J: "The design of a 6-port active calculator" 19880525; 19880525 - 19880527, 25 mai 1988 (1988-05-25), pages 1011-1014, XP010070002

## Description

L'invention concerne un duplexeur actif hyperfréquence commandé. Elle concerne également un module d'émission et de réception comportant un tel duplexeur actif hyperfréquence. L'invention s'applique notamment au domaine des modules d'émission et de réception utilisant une seule antenne pour l'émission et la réception. Elle s'applique plus particulièrement au domaine des modules d'émission et de réception des systèmes aéroportés fonctionnant dans une large bande de fréquences.

Le document US 3 088 105 décrit un duplexeur comprenant deux amplificateurs distribués.

Les modules d'émission et de réception utilisant une seule antenne pour l'émission et la réception, comme par exemple les modules d'émission et de réception équipant certains radars, doivent comporter des moyens permettant de séparer les signaux émis des signaux reçus par l'antenne. En effet, la chaîne d'émission et la chaîne de réception présentant des caractéristiques électriques différentes, l'utilisation d'une même antenne pour l'émission et la réception de signaux nécessite de séparer les signaux émis des signaux reçus au plus près de l'antenne. Pour un bon fonctionnement du module d'émission et de réception, les moyens permettant de séparer les signaux émis des signaux reçus doivent satisfaire différentes contraintes. Premièrement, ils doivent assurer un bon isolement entre la voie d'émission et la voie de réception de façon à éviter que le récepteur, dont la sensibilité est importante, ne soit perturbé voire endommagé par la réception indésirable d'une fraction trop importante du signal émis. L'isolement entre la voie d'émission et la voie de réception est d'autant plus important que l'écart de niveau de puissance entre le signal émis et le signal reçu peut atteindre un rapport de l'ordre de 10000, voire plus. Deuxièmement, ces moyens doivent assurer en mode de réception une transmission du signal reçu vers le récepteur avec un minimum de pertes, la puissance du signal reçu étant généralement faible, voire très faible. Troisièmement, ces moyens doivent assurer en mode d'émission une transmission du signal émis vers l'antenne avec un minimum de pertes pour ne pas dégrader le rendement en puissance du module d'émission et de réception. Par ailleurs, le besoin croissant d'intégration des systèmes aéroportés conduit à réduire le poids et l'encombrement des dispositifs de traitement du signal, favorisant ainsi le développement de modules d'émission et de réception implantés au plus près de l'antenne.

Pour des applications à bande de fréquences relativement étroite, de l'ordre d'une octave, les moyens permettant de séparer les signaux émis des signaux reçus sont généralement conçus en deux parties :
- une première partie traite l'aiguillage du signal au pied de l'antenne entre les voies d'émission et de réception ;
- une deuxième partie couvre la commutation du traitement du signal selon le mode de fonctionnement.

L'aiguillage du signal au pied de l'antenne est généralement réalisé par un circuit passif non réciproque du type circulateur à ferrite. Un circulateur hyperfréquence assure efficacement sa fonction. Il peut être mis en cascade avec un ou plusieurs autres circulateurs, afin notamment de renforcer l'isolement entre voies. En revanche, un circulateur présente un encombrement et un poids importants, qui sont pénalisants pour les systèmes aéroportés. De plus, la bande passante d'un circulateur s'avère insuffisante pour les applications à très large bande, typiquement de l'ordre de 3 octaves et plus. Pour les applications à très large bande, l'aiguillage entre la voie d'émission et la voie de réception peut être réalisé à partir d'un commutateur passif. Cependant, un commutateur passif présente pour principale limitation l'absence de directivité entre l'entrée et la sortie d'une même voie de celui-ci. Autrement dit, l'entrée et la sortie d'une voie du commutateur passif sont en liaison directe et bilatérale, aux pertes de transmission près, lorsque cette voie du commutateur est enclenchée. L'absence de directivité pose notamment problème lorsque l'antenne présente un fort coefficient de réflexion. Une partie du signal à émettre est alors réfléchie vers l'amplificateur de puissance, pouvant entraîner son dysfonctionnement, voire sa destruction. Une autre solution pour les applications à très large bande consiste à séparer physiquement la voie d'émission de la voie de réception. Cette séparation présente un inconvénient évident, c'est la duplication d'une partie de la chaîne de traitement du signal et des éléments rayonnants, ce qui est contraire à la philosophie d'un module d'émission et de réception et au besoin d'intégration des dispositifs électroniques.

Un but de l'invention est notamment de pallier tout ou partie des inconvénients précités. A cet effet, l'invention a pour objet un duplexeur actif hyperfréquence commandé comportant un port d'entrée, un port d'entrée/sortie et un port de sortie et permettant le passage d'un signal hyperfréquence du port d'entrée vers le port d'entrée/sortie et du port d'entrée/sortie vers le port de sortie. Selon l'invention, le duplexeur actif comprend deux amplificateurs distribués et des moyens pour les commander. Chaque amplificateur distribué comporte une ligne d'entrée et une ligne de sortie, la ligne de sortie du premier amplificateur distribué étant commune à la ligne d'entrée du deuxième amplificateur distribué. Une extrémité de la ligne d'entrée du premier amplificateur distribué forme le port d'entrée ; une extrémité de la ligne de sortie du deuxième amplificateur distribué forme le port de sortie et une extrémité de la ligne commune aux deux amplificateurs distribués forme le port d'entrée/sortie. Le premier amplificateur distribué est commandé à l'état passant et le deuxième amplificateur distribué est commandé à l'état bloqué lorsqu'un signal hyperfréquence est susceptible de passer du port d'entrée au port d'entrée/sortie, et le premier amplificateur distribué est commandé à l'état bloqué et le deuxième amplificateur distribué est commandé à l'état passant lorsqu'un signal hyperfréquence est susceptible de passer du port d'entrée/sortie au port de sortie.

L'invention a également pour objet un module d'émission et de réception comportant un duplexeur actif hyperfréquence tel que décrit ci-dessus. Le port d'entrée est relié à une voie d'émission, le port d'entrée/sortie est apte à être relié à une antenne et le port de sortie est relié à une voie de réception.

L'invention a notamment pour avantage qu'elle permet de réaliser l'aiguillage des signaux hyperfréquences avec un faible encombrement et une bonne isolation entre le port d'entrée et le port de sortie.

L'invention sera mieux comprise et d'autres avantages apparaîtront à la lecture de la description détaillée d'un mode de réalisation donné à titre d'exemple, description faite en regard de dessins annexés qui représentent :
- la figure 1, une illustration de moyens permettant de séparer les signaux émis des signaux reçus et pouvant être implantés dans un module d'émission et de réception selon l'art antérieur pour une application à bande étroite ;
- la figure 2, une illustration d'un amplificateur distribué tel qu'il est connu de l'état de la technique ;
- la figure 3, une illustration du principe de réalisation du duplexeur actif hyperfréquence commandé selon l'invention ;
- la figure 4, des courbes d'évolution en fonction de la fréquence de paramètres de transmission entre différents accès de l'amplificateur distribué de la figure 2 ;
- la figure 5, un exemple de réalisation d'un duplexeur actif hyperfréquence commandé selon l'invention ;
- la figure 6, un schéma électrique équivalent du duplexeur actif hyperfréquence commandé tel que présenté à la figure 5 dans le mode d'émission ;
- la figure 7, un schéma électrique équivalent du duplexeur actif hyperfréquence commandé tel que présenté à la figure 5 dans le mode de réception.

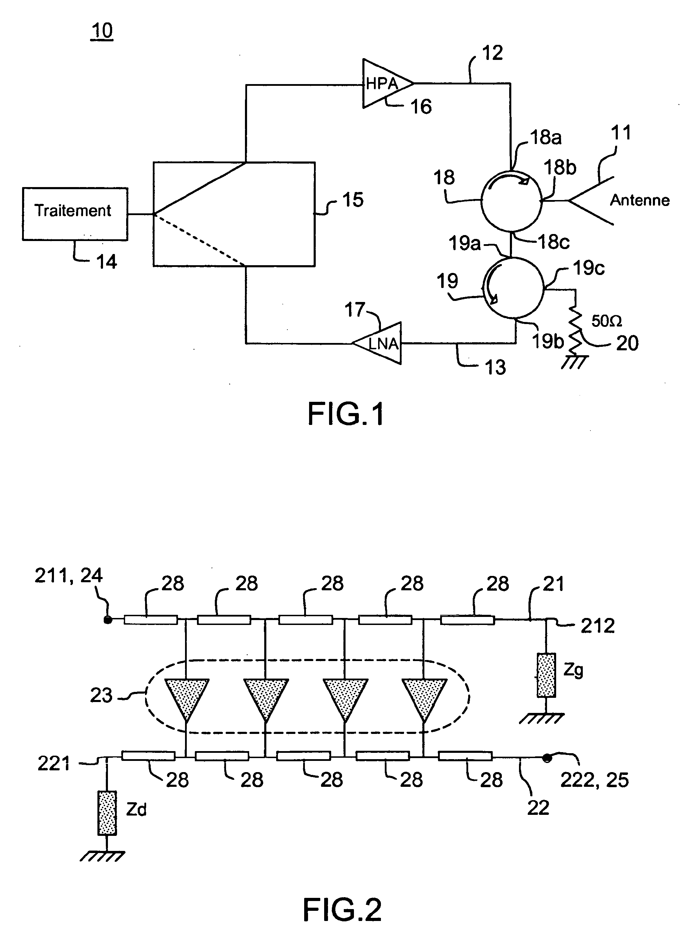

La figure 1 illustre, par un synoptique, des moyens 10 permettant de séparer les signaux émis des signaux reçus par une antenne 11, ces moyens 10 pouvant être implantés dans un module d'émission et de réception pour une application à bande étroite. Comme indiqué précédemment, ces moyens 10 effectuent d'une part l'aiguillage des signaux au pied de l'antenne 11 entre la voie d'émission 12 et la voie de réception 13 et d'autre part la commutation du traitement des signaux selon le mode de fonctionnement, à savoir le mode d'émission ou le mode de réception. Les voies d'émission 12 et de réception 13 sont reliées à des moyens de traitement 14 par un commutateur 15. Le commutateur 15 assure la liaison entre les moyens de traitement 14 et l'une ou l'autre des voies d'émission 12 et de réception 13, selon le mode de fonctionnement en cours. La voie d'émission 12 comporte généralement un amplificateur de puissance 16 destiné à amplifier le signal basse puissance issu des moyens de traitement 14, le signal amplifié étant destiné à être émis par l'antenne 11. La voie de réception 13 comporte généralement un amplificateur faible bruit 17 pour amplifier le signal de faible puissance reçu par l'antenne 11 et à destination des moyens de traitement 14. Dans l'exemple de la figure 1, l'aiguillage est effectué au moyen de deux circulateurs 18 et 19 hyperfréquences. Le premier circulateur 18 reçoit sur une entrée 18a les signaux amplifiés issus de l'amplificateur de puissance 16. Une entre/sortie 18b du circulateur 18 est reliée à l'antenne 11, si bien que le signal amplifié est dirigé vers cette dernière. La fonction de commutation est placée en amont de l'amplificateur de puissance 16. Les signaux qui passent par le commutateur 15 peuvent alors être de faible puissance. A la réception, les signaux issus de l'antenne 11 entrent sur l'entrée/sortie 18b du premier circulateur 18 pour être dirigés vers une sortie 18c reliée à une entrée 19a du deuxième circulateur 19. Le signal reçu est dirigé à l'intérieur du circulateur 19 vers une entrée/sortie 19b reliée à la voie de réception 13 et notamment à l'entrée de l'amplificateur faible bruit 17. La sortie 19c du deuxième circulateur 19 est reliée à une charge 50 ohm 20. Le deuxième circulateur 19 renforce l'isolement entre la voie d'émission 12 et la voie de réception 13. Le nombre de circulateurs utilisés dépend du niveau d'isolation recherché entre les voies d'émission 12 et de réception 13. Dans le cas d'une isolation minimale, la sortie 18c du premier circulateur 18 est directement reliée à l'entrée de l'amplificateur faible bruit 17.

L'utilisation de circulateurs permet de dissocier au niveau de l'antenne 11 les chemins d'émission 12 et de réception 13. Les circulateurs étant des éléments passifs, ils sont naturellement aptes à faire passer des signaux de forte puissance venant de l'amplificateur de puissance 16. Cependant, en raison de leur poids, de leur volume et de leur bande passante limitée, les circulateurs sont inadaptés aux applications large bande des systèmes aéroportés.

La présente invention repose sur la combinaison de deux amplificateurs distribués.

La figure 2 illustre, par un synoptique, la structure d'un amplificateur distribué. Un tel dispositif comporte essentiellement une ligne d'entrée 21 et une ligne de sortie 22 reliées par des cellules actives 23. Les lignes d'entrée 21 et de sortie 22 sont généralement refermées à l'une de leur extrémité, respectivement 212 et 221, par une impédance de charge, respectivement Zg et Zd, dont la valeur est en principe égale à l'impédance caractéristique de la ligne en question. Les extrémités libres 211 et 222 des lignes d'entrée 21 et de sortie 22 forment respectivement un port d'entrée 24 et un port de sortie 25 pour l'amplificateur distribué. Le port d'entrée 24 et le port de sortie 25 sont situés à l'opposé l'un de l'autre. Les cellules actives 23 peuvent notamment comprendre chacune un transistor, par exemple un transistor à effet de champ en mode source commune dont la grille est reliée à la ligne d'entrée 21 et dont le drain est relié à la ligne de sortie 22. Dans ce cas, la ligne d'entrée 21 est communément appelée ligne de grille et la ligne de sortie, ligne de drain. Les cellules actives 23 peuvent également comprendre un montage associant plusieurs transistors, par exemple un montage de type Darlington, cascade ou cascode.

Les lignes d'entrée 21 et de sortie 22 sont chacune constituées d'une combinaison entre des inductances et les accès des transistors, qui ont des propriétés capacitives. Par exemple, dans le cas d'un transistor à effet de champ, les accès de grille (en entrée) et de drain (en sortie) sont équivalents à des condensateurs de capacité Cgs en entrée et de capacité Cds en sortie. Les inductances peuvent être physiquement réalisées par des tronçons de lignes 28 hyperfréquences à haute impédance caractéristique, telles que des lignes microrubans de faible largeur. Elles peuvent également être réalisées par des composants en forme de spirale. Pour augmenter la bande passante, on peut aussi introduire un effet de mutuelle inductance entre deux inductances consécutives en utilisant des spirales imbriquées. Sur la figure 2, les lignes d'entrée 21 et de sortie 22 sont représentées symboliquement par des tronçons de lignes 28 reliant les différentes cellules actives 23.

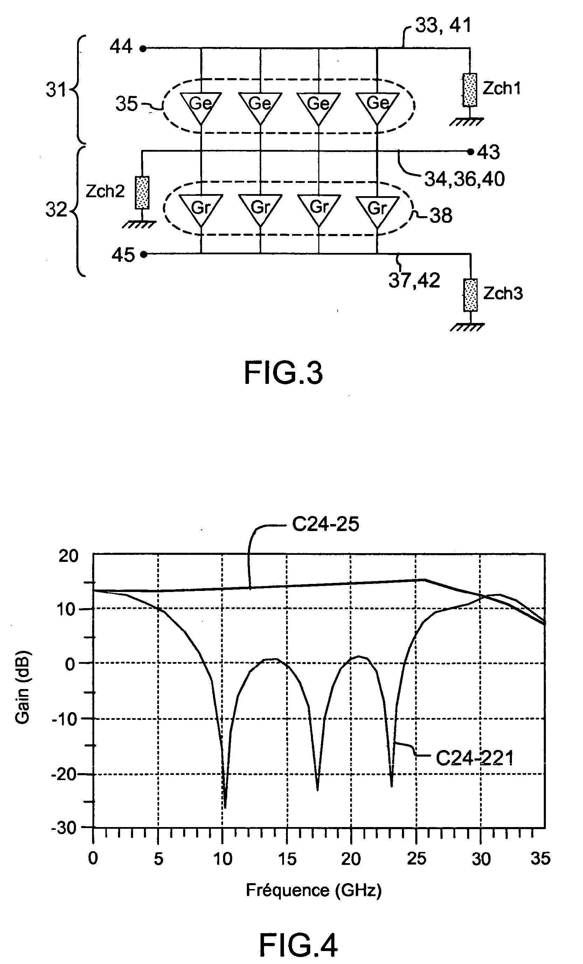

La figure 3 illustre le principe de réalisation d'un duplexeur actif hyperfréquence commandé selon l'invention. Ledit duplexeur actif hyperfréquence comporte deux amplificateurs distribués 31 et 32 tels que décrits en référence à la figure 2. En particulier, le premier amplificateur distribué 31 comprend une première ligne d'entrée 33 et une première ligne de sortie 34, ces lignes étant reliées par des cellules actives 35. Le deuxième amplificateur distribué 32 comprend une seconde ligne d'entrée 36 et une seconde ligne de sortie 37. De même, les secondes lignes d'entrée 36 et de sortie 37 sont reliées par des cellules actives 38. Selon l'invention, la première ligne de sortie 34 est commune à la seconde ligne d'entrée 36. Autrement dit, la première ligne de sortie 34 et la seconde ligne de sortie 36 sont physiquement réalisées par une seule et même ligne physique, appelée ligne centrale 40. La première ligne d'entrée 33, appelée ligne d'entrée 41, la ligne centrale 40 et la seconde ligne de sortie 37, appelée ligne de sortie 42, sont chacune refermées sur une impédance de charge, respectivement Zch1, Zch2 et Zch3, égale à l'impédance caractéristique de la ligne 40, 41 ou 42 respective. Les extrémités libres des lignes centrale 40, d'entrée 41 et de sortie 42 forment respectivement un port d'entrée/sortie 43, un port d'entrée 44 et un port de sortie 45.

La figure 3 présente un cas particulier où les amplificateurs distribués 31 et 32 comportent chacun le même nombre de cellules actives 35 et 38. Cependant, le nombre de cellules actives 35 est tout à fait indépendant du nombre de cellules actives 38.

Selon une forme particulière de réalisation, le port d'entrée/sortie 43 est situé à l'opposé du port d'entrée 44 et du port de sortie 45, comme représenté à la figure 3. Cette forme de réalisation, particulièrement avantageuse, est conforme à l'agencement habituel d'un amplificateur distribué pour lequel le port de sortie est situé du côté opposé au port d'entrée. Dans le cadre de l'invention, cet agencement permet d'obtenir une bonne isolation entre le port d'entrée 44 et le port de sortie 45. En effet, le port d'entrée 44 et le port de sortie 45 se trouvent naturellement isolés l'un de l'autre par les caractéristiques d'un amplificateur distribué et ce, indépendamment de l'état bloqué ou passant des cellules actives 35 et 38.

La figure 4 permet de mettre en évidence l'isolation apportée par l'agencement d'un amplificateur distribué tel que représenté à la figure 2. Cette figure présente des courbes d'évolution en fréquence de différents paramètres de transmission relatifs à un amplificateur distribué tel que représenté à la figure 2 et pour lequel les extrémités 212 et 221 ne sont plus refermées sur les impédances de fermeture respectives Zg et Zd mais forment des ports d'entrée/sortie. Une première courbe C24-25 représente le coefficient de transmission, exprimé en dB, entre le port d'entrée 24 et le port de sortie 25. Une deuxième courbe C24-221 représente le coefficient de transmission, toujours exprimé en dB, entre le port d'entrée 24 et l'extrémité 221 de la ligne de sortie 22. La première courbe C24-25 permet de vérifier qu'un signal injecté sur le port d'entrée 24 ressort amplifié sur le port de sortie 25. L'amplification est relativement uniforme sur la bande passante de l'amplificateur distribué. Cette caractéristique est due au fait qu'un signal entrant sur le port d'entrée 24 se propage sur la ligne d'entrée 21 et se couple activement à la ligne de sortie 22. Par couplage actif, on entend le fait qu'un signal propagé sur la ligne d'entrée 21 se décompose en signaux élémentaires, ces signaux élémentaires étant amplifiés en passant chacun par une cellule active 23, les signaux élémentaires amplifiés se recombinant en phase au niveau du port de sortie 25. A l'inverse, la portion de signal reçue sur l'extrémité 221 de la ligne de sortie 22, représentée par la courbe C24-221, est largement atténuée sur certaines bandes de fréquences. L'atténuation est due au fait que les signaux élémentaires sont déphasés les uns par rapport aux autres au niveau de l'extrémité 221 de la ligne de sortie 22.

Le principe d'isolation naturelle d'un amplificateur distribué se retrouve évidemment dans le duplexeur actif hyperfréquence selon l'invention, par exemple représenté à la figure 3. En effet, du fait de la combinaison de deux amplificateurs distribués, un signal entrant sur le port d'entrée 44 est amplifié en sortie sur le port d'entrée/sortie 43, de même qu'un signal entrant sur le port d'entrée/sortie 43 est amplifié en sortie sur le port de sortie 45, alors qu'un signal entrant sur le port d'entrée 44 est fortement atténué en sortie sur le port de sortie 45.

Le principe d'isolation naturelle et d'amplification uniforme est d'autant plus effectif que les cellules actives 35 d'une part, et 38 d'autre part sont réparties uniformément entre les lignes d'entrée 33, 36 et de sortie 34, 37 respectives. Par répartition uniforme, on entend le fait que les longueurs électriques équivalentes des différents chemins empruntés par les signaux élémentaires entre le port d'entrée 44 et le port d'entrée/sortie 43 ou entre le port d'entrée/sortie 43 et le port de sortie 45 sont égales, de sorte que le signal hyperfréquence se recombine en phase respectivement sur la ligne de sortie 34 ou 37 du premier ou du deuxième amplificateur distribué 31 ou 32 suivant que le signal hyperfréquence entre respectivement sur la ligne d'entrée 33 ou la ligne d'entrée 36.

Selon une forme particulière de réalisation, le duplexeur actif hyperfréquence comprend un circuit de commande permettant de commander les cellules actives 35 et 38 en fonction du mode d'émission ou de réception. En particulier, dans le mode d'émission, autrement dit lorsqu'un signal hyperfréquence est susceptible de passer du port d'entrée 44 au port d'entrée/sortie 43, le circuit de commande commande à l'état passant les cellules actives 35 du premier amplificateur distribué 31 et à l'état bloqué les cellules actives 38 du deuxième amplificateur distribué 32. A l'inverse, dans le mode de réception, autrement dit lorsqu'un signal hyperfréquence est susceptible de passer du port d'entrée/sortie 43 au port de sortie 45, le circuit de commande commande à l'état bloqué les cellules actives 35 du premier amplificateur distribué 31 et à l'état passant les cellules actives 38 du deuxième amplificateur distribué 32. Cette forme de réalisation permet de renforcer l'isolation entre les ports d'entrée 44 et de sortie 45.

Avantageusement, les cellules actives 35 et 38 comportent chacune un transistor. Ces transistors sont par exemple des transistors à effet de champ montés en mode source commune. Les grilles des transistors des cellules actives 35 peuvent être reliées à la ligne d'entrée 41 et leurs drains peuvent être reliés à la ligne centrale 40. De même, les grilles des transistors des cellules actives 38 peuvent être reliées à la ligne centrale 40 et leurs drains peuvent être reliés à la ligne de sortie 42. L'utilisation de transistors permet d'amplifier les signaux passant par les cellules actives 35 et 38. Le gain Ge d'amplification des cellules actives 35 peut être différent du gain Gr d'amplification des cellules actives 38. Avantageusement, les transistors sont dimensionnés de telle manière que le premier amplificateur distribué 31 du duplexeur actif hyperfréquence commandé puisse se substituer à l'amplificateur de puissance 16 du dispositif de commutation 10 représenté à la figure 1 et que le deuxième amplificateur distribué 32 puisse se substituer à l'amplificateur faible bruit 17 de ce dispositif de commutation 10.

Dans un mode particulier de réalisation, les cellules actives 35 et 38 comportent chacune un montage associant plusieurs transistors, par exemple un montage Darlington ou un montage cascode. L'utilisation de plusieurs transistors par cellule active 35 ou 38 présente notamment l'avantage de pouvoir facilement ajuster les gains Ge et Gr des cellules actives 35 et 38.

Toujours avantageusement, les transistors des cellules actives 35 et 38 sont fabriqués en utilisant une technologie de semi-conducteurs de type III-V à grand gap, comme par exemple le Nitrure de Gallium (GaN). Cette technologie permet de réaliser des composants dont les tensions de claquage sont élevées et les densités de puissance importantes. Ces caractéristiques présentent plusieurs avantages. En mode de réception, le duplexeur actif hyperfréquence commandé présente une relativement grande robustesse face aux agressions extérieures telles que les champs forts. La présence d'un dispositif de protection n'est alors plus nécessaire. Ceci a pour conséquence une amélioration du facteur de bruit et donc de la sensibilité de la chaîne de réception. En mode d'émission, il est possible de réaliser l'amplification de puissance uniquement avec les cellules actives 35 du premier amplificateur distribué 31.

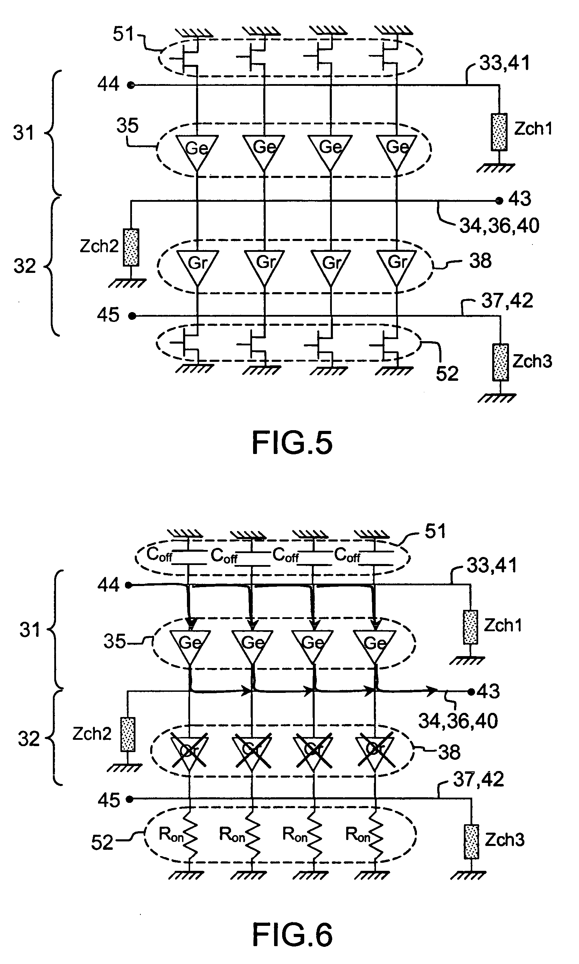

La figure 5 illustre un duplexeur actif hyperfréquence commandé selon une forme particulière de réalisation de l'invention. Selon cette forme particulière de réalisation, le duplexeur actif hyperfréquence comprend, en outre, des éléments de commutation 51 répartis le long de la ligne d'entrée 41 et permettant de relier cette ligne à un plan de masse. Les éléments de commutation 51 comprennent par exemple des transistors dits "froids", c'est-à-dire des transistors à effet de champ dont la tension continue entre le drain et la source est toujours nulle. De même, le duplexeur actif hyperfréquence peut comprendre des éléments de commutation 52 répartis le long de la ligne de sortie 42 et permettant de relier cette ligne à un plan de masse. Les éléments de commutation 52 comprennent par exemple des transistors froids.

Les caractéristiques d'un transistor froid sont les suivantes. Lorsque le transistor froid est passant, par exemple pour une tension Vgs continue et égale à 0,5 V appliquée entre sa grille et sa source, le transistor présente les caractéristiques d'une faible résistance Rₒₙ entre son drain et sa source. Lorsque le transistor froid est bloqué, par exemple pour une tension Vgs continue et égale à -2,2 V, le transistor présente les caractéristiques d'une capacité C_{off}.

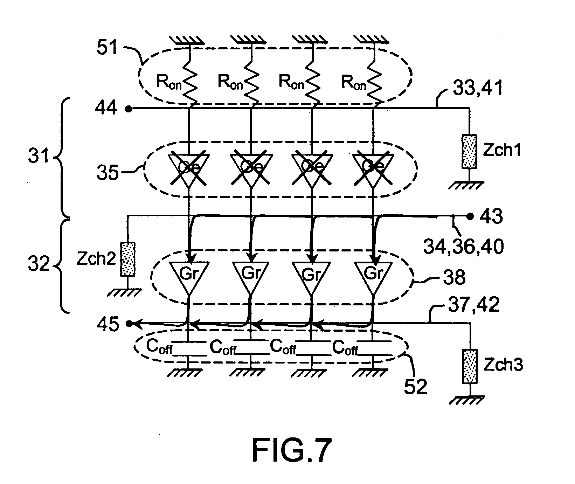

Avantageusement, le duplexeur actif hyperfréquence comprend un circuit de commande permettant de commander les éléments de commutation 51 et 52 en fonction du mode d'émission ou de réception. En particulier, dans le mode d'émission, représenté à la figure 6, le circuit de commande commande à l'état bloqué les éléments de commutation 51 et à l'état passant les éléments de commutation 52. Par conséquent, la ligne d'entrée 41 conserve les caractéristiques d'une ligne de propagation tandis que la ligne de sortie 42 possède des connections régulières à la masse, absorbant un éventuel signal de fuite arrivant sur la ligne de sortie 42 et réduisant ainsi la propagation de ce signal de fuite vers le port de sortie 45. A l'inverse, dans le mode de réception, représenté à la figure 7, le circuit de commande commande à l'état passant les éléments de commutation 51 et à l'état bloqué les éléments de commutation 52. La ligne d'entrée 41 possède alors des connections régulières à la masse, capable d'absorber un éventuel signal de fuite, tandis que la ligne de sortie 42 conserve les caractéristiques d'une ligne de propagation.

Il est à noter que, afin de ne pas réduire les bandes passantes des premier et deuxième amplificateurs distribués 31 et 32, les capacités C_{off} doivent rester faibles. Autrement dit les transistors froids doivent être de petite taille.

La forme particulière de réalisation faite en référence aux figures 5 à 7 décrit un duplexeur actif hyperfréquence comprenant à la fois des éléments de commutation 51 répartis sur la ligne d'entrée 41 et des éléments de commutation 52 répartis sur la ligne de sortie 42. Cependant, le duplexeur actif hyperfréquence peut tout aussi bien comprendre des éléments de commutation 51 ou 52 uniquement sur l'une des deux lignes d'entrée 41 et de sortie 42. De même, la figure 5 présente un cas particulier où un élément de commutation 51, respectivement 52, est présent pour chaque cellule active 35, respectivement 38. Le nombre d'éléments de commutation 51 et 52 peut cependant être tout à fait indépendant du nombre de cellules actives 35 et 38.

Le duplexeur actif hyperfréquence tel que décrit ci-dessus peut être implanté dans un module d'émission et de réception, par exemple un module d'émission et de réception d'un système aéroporté. Le port d'entrée 44 peut être relié à une voie d'émission, par exemple une sortie d'un amplificateur de puissance, le port d'entrée/sortie 43 peut être relié à une antenne et le port de sortie 45 peut être relié à une voie de réception, par exemple une entrée d'un amplificateur faible bruit. En commandant de façon adéquate le fonctionnement des cellules actives 35 et 38, le duplexeur actif hyperfréquence commandé peut alors assurer une fonction équivalente aux circulateurs 18 et 19, en permettant le passage d'un signal hyperfréquence du port d'entrée 44 au port d'entrée/sortie 43 et du port d'entrée/sortie 43 au port de sortie 45.

## Revendications

1. Duplexeur actif hyperfréquence commandé comportant un port d'entrée (44), un port d'entrée/sortie (43) et un port de sortie (45) et permettant le passage d'un signal hyperfréquence du port d'entrée (44) vers le port d'entrée/sortie (43) et du port d'entrée/sortie (43) vers le port de sortie (45), **caractérisé en ce qu'**il comprend deux amplificateurs distribués (31, 32) et des moyens pour commander lesdits amplificateurs distribués (31, 32), chaque amplificateur distribué (31, 32) comportant une ligne d'entrée (33, 36) et une ligne de sortie (34, 37), la ligne de sortie (34) du premier amplificateur distribué (31) étant commune à la ligne d'entrée (36) du deuxième amplificateur distribué (32), une extrémité de la ligne d'entrée (33) du premier amplificateur distribué (31) formant le port d'entrée (44), une extrémité de la ligne de sortie (37) du deuxième amplificateur distribué (32) formant le port de sortie (45) et une extrémité de la ligne commune aux deux amplificateurs distribués (31, 32) formant le port d'entrée/sortie (43), le premier amplificateur distribué (31) étant commandé à l'état passant et le deuxième amplificateur distribué (32) étant commandé à l'état bloqué lorsqu'un signal hyperfréquence est susceptible de passer du port d'entrée (44) au port d'entrée/sortie (43), le premier amplificateur distribué (31) étant commandé à l'état bloqué et le deuxième amplificateur distribué (32) étant commandé à l'état passant lorsqu'un signal hyperfréquence est susceptible de passer du port d'entrée/sortie (43) au port de sortie (45).

2. Duplexeur actif selon la revendication 1, **caractérisé en ce que** chaque amplificateur distribué (31, 32) comporte des transistors en parallèle entre sa ligne d'entrée (33, 36) et sa ligne de sortie (34, 37), les transistors étant répartis uniformément de sorte que quel que soit le transistor emprunté par le signal hyperfréquence entre le port d'entrée (44) et le port d'entrée/sortie (43) ou entre le port d'entrée/sortie (43) et le port de sortie (45), le signal hyperfréquence se recombine en phase respectivement sur la ligne de sortie (34, 37) du premier ou du deuxième amplificateur distribué (31, 32).

3. Duplexeur actif selon la revendication 2, **caractérisé en ce que** les transistors comprennent des matériaux semi-conducteurs de type III-V à grand gap.

4. Duplexeur actif selon l'une quelconque des revendications précédentes, **caractérisé en ce qu'**il comprend des éléments de commutation (51) répartis le long de la ligne d'entrée (33) du premier amplificateur distribué (31) permettant de relier ladite ligne d'entrée (33) à un plan de masse.

5. Duplexeur actif selon l'une quelconque des revendications précédentes, **caractérisé en ce qu'**il comprend des éléments de commutation (52) répartis le long de la ligne de sortie (37) du deuxième amplificateur distribué (32) permettant de relier ladite ligne de sortie (37) à un plan de masse.

6. Duplexeur actif selon les revendications 4 et 5, **caractérisé en ce qu'**il comprend des moyens pour rendre bloqués les éléments de commutation (51) répartis le long de la ligne d'entrée (33) du premier amplificateur distribué (31) et passants les éléments de commutation (52) répartis le long de la ligne de sortie (37) du deuxième amplificateur distribué (32) lorsqu'un signal hyperfréquence doit passer du port d'entrée (44) au port d'entrée/sortie (43) et des moyens pour rendre passants les éléments de commutation (51) répartis le long de la ligne d'entrée (33) du premier amplificateur distribué (31) et bloqués les éléments de commutation (52) répartis le long de la ligne de sortie (37) du deuxième amplificateur distribué (32) lorsqu'un signal hyperfréquence doit passer du port d'entrée/sortie (43) au port de sortie (45).

7. Duplexeur actif selon les revendications 4 et 5 ou selon la revendication 6, **caractérisé en ce que** les éléments de commutation (51) répartis le long de la ligne d'entrée (33) du premier amplificateur distribué (31) et les éléments de commutation (52) répartis le long de la ligne de sortie (37) du deuxième amplificateur distribué (32) sont des transistors à effet de champ de tension nulle entre leur drain et leur source.

8. Module d'émission et de réception, **caractérisé en ce qu'**il comprend un duplexeur actif hyperfréquence commandé selon l'une quelconque des revendications précédentes, le port d'entrée (44) étant relié à une voie d'émission, le port d'entrée/sortie (43) étant apte à être relié à une antenne et le port de sortie (45) étant relié à une voie de réception.

9. Module selon la revendication 8, **caractérisé en ce que** la voie d'émission comporte un amplificateur de puissance relié en amont à un point apte à être connecté à des moyens de traitement et la voie de réception comporte un amplificateur faible bruit relié en aval à un point apte à être connecté à des moyens de traitement.

## Claims

1. A controlled RF active duplexer comprising an input port (44), an input/output port (43) and an output port (45) and allowing the passage of an RF signal from the input port (44) to the input/output port (43) and from the input/output port (43) to the output port (45), **characterized in that** it comprises two distributed amplifiers (31, 32) and means for controlling said distributed amplifiers (31, 32), each distributed amplifier (31, 32) comprising an input line (33, 36) and an output line (34, 37), the output line (34) of the first distributed amplifier (31) being common to the input line (36) of the second distributed amplifier (32), an end of the input line (33) of the first distributed amplifier (31) forming the input port (44), an end of the output line (37) of the second distributed amplifier (32) forming the output port (45) and an end of the line common to the two distributed amplifiers (31, 32) forming the input/output port (43), the first distributed amplifier (31) being placed in the on state and the second distributed amplifier (32) being placed in the off state when an RF signal is apt to pass from the input port (44) to the input/output (43), the first distributed amplifier (31) being placed in the off state and the second distributed amplifier (32) being placed in the on state when an RF signal is apt to pass from the input/output port (43) to the output port (45).

2. Active duplexer according to Claim 1, charachterized in that each distributed amplifier (31, 32) comprises transistors in parallel between its input line (33, 36) and its output line (34, 37), the transistors being spread out uniformly so that whichever transistor is traversed by the RF signal between the input port (44) and the input/output port (43) or between the input/output port (43) and the output port (45), the RF signal is recombined in phase respectively on the output line (34, 37) of the first or of the second distributed amplifier (31, 32).

3. Active duplexer according to Claim 2, **characterized in that** the transistors comprise wide-gap III-V type semiconductor materials.

4. Active duplexer according to any preceding claims, **characterized in that** it comprises switching elements (51) spread out along the input line (33) of the first distributed amplifier (31) making it possible to link said input line (33) to a ground plane.

5. Active duplexer according to any preceding claims, **characterized in that** it comprises switching elements (52) spread out along the output line (37) of the second distributed amplifier (32) making it possible to link said output line (37) to a ground plane.

6. Active duplexer according to claims 4 and 5, **characterized in that** it comprises means for turning off the switching elements (51) spread out along the input line (33) of the first distributed amplifier (31) and for turning on the switching elements (52) spread out along the output line (37) of the second distributed amplifier (32) when an RF signal has to pass from the input port (44) to the input/output port (43) and means for turning on the switching elements (51) spread out along the input line (33) of the first distributed amplifier (31) and for turning off the switching elements (52) spread out along the output line (37) of the second distributed amplifier (32) when an RF signal has to pass from the input/output port (43) to the output port (45).

7. Active duplexer according to claims 4 and 5, **characterized in that** the switching elements (51) spread out along the input line (33) of the first distributed amplifier (31) and the switching elements (52) spread out along the output line (37) of the second distributed amplifier (32) are field-effect transistors whose DC voltage between their drain and their source is always zero.

8. Transmission and reception module, **characterized in that** it comprises the controlled RF active duplexer according to any preceding claims, the input port (44) being linked to a transmit pathway, the input/output port (43) being able to be linked to an antenna and the output port (45) being linked to a receive pathway.

9. Module according to Claim 8, **characterized in that** the transmit pathway comprises a power amplifier linked upstream to a point able to be connected to processing means and the receive pathway comprises a low noise amplifier linked downstream to a point able to be connected to processing means.

## Patentansprüche

1. Gesteuerter aktiver Mikrowellen-Duplexer, der einen Eingangsport (44), einen Ein-/Ausgangsport (43) und einen Ausgangsport (45) umfasst und ein Mikrowellensignal vom Eingangsport (44) zum Ein-/Ausgangsport (43) und vom Ein-/Ausgangsport (43) zum Ausgangsport (45) passieren lässt, **dadurch gekennzeichnet, dass** er zwei Kettenverstärker (31, 32) und Mittel zum Steuern der Kettenverstärker (31, 32) umfasst, wobei jeder Kettenverstärker (31, 32) eine Eingangsleitung (33, 36) und eine Ausgangsleitung (34, 37) umfasst, wobei die Ausgangsleitung (34) des ersten Kettenverstärkers (31) mit der Eingangsleitung (36) des zweiten Kettenverstärkers (32) gemeinsam ist, wobei ein Ende der Eingangsleitung (33) des ersten Kettenverstärkers (31) den Eingangsport (44) bildet, wobei ein Ende der Ausgangsleitung (37) des zweiten Kettenverstärkers (32) den Ausgangsport (45) bildet und wobei ein Ende der den zwei Kettenverstärkern (31, 32) gemeinsamen Leitung den Ein-/Ausgangsport (43) bildet, wobei der erste Kettenverstärker (31) in den Durchlasszustand gesteuert wird und der zweite Kettenverstärker (32) in den Sperrzustand gesteuert wird, wenn die Möglichkeit besteht, dass ein Mikrowellensignal vom Eingangsport (44) zum Ein-/Ausgangsport (43) passiert, wobei der erste Kettenverstärker (31) in den Sperrzustand gesteuert wird und der zweite Kettenverstärker (32) in den Durchlasszustand gesteuert wird, wenn die Möglichkeit besteht, dass ein Mikrowellensignal vom Ein-/Ausgangsport (43) zum Ausgangsport (45) passiert.

2. Aktiver Duplexer nach Anspruch 1, **dadurch gekennzeichnet, dass** jeder Kettenverstärker (31, 32) Transistoren parallel zwischen seiner Eingangsleitung (33, 36) und seiner Ausgangsleitung (34, 37) umfasst, wobei die Transistoren gleichförmig verteilt sind, so dass das Mikrowellensignal unabhängig davon, welcher Transistor von dem Mikrowellensignal zwischen dem Eingangsport (44) und dem Ein-/Ausgangsport (43) oder zwischen dem Ein-/Ausgangsport (43) und dem Ausgangsport (45) benutzt wird, gleichphasig jeweils auf der Ausgangsleitung (34, 37) des ersten oder des zweiten Kettenverstärkers (31, 32) rekombiniert wird.

3. Aktiver Duplexer nach Anspruch 2, **dadurch gekennzeichnet, dass** die Transistoren Halbleitermaterialien des Typs III-V mit breitem Bandabstand umfassen.

4. Aktiver Duplexer nach einem der vorherigen Ansprüche, **dadurch gekennzeichnet, dass** er Kommutationselemente (51) umfasst, die entlang der Eingangsleitung (33) des ersten Kettenverstärkers (31) verteilt sind und eine Verbindung der Eingangsleitung (33) mit einer Masseplatte zulassen.

5. Aktiver Duplexer nach einem der vorherigen Ansprüche, **dadurch gekennzeichnet, dass** er Kommutationselemente (52) umfasst, die entlang der Ausgangsleitung (37) des zweiten Kettenverstärkers (32) verteilt sind und eine Verbindung der Eingangsleitung (37) mit einer Masseplatte zulassen.

6. Aktiver Duplexer nach Anspruch 4 und 5, **dadurch gekennzeichnet, dass** er Mittel zum Sperrendmachen der Kommutationselemente (51), die entlang der Eingangsleitung (33) des ersten Kettenverstärkers (31) verteilt sind, und zum Durchlässigmachen der Kommutationselemente (52) umfasst, die entlang der Ausgangsleitung (37) des zweiten Kettenverstärkers (32) verteilt sind, wenn ein Mikrowellensignal vom Eingangsport (44) zum Ein-/Ausgangsport (43) passieren soll, und Mittel zum Durchlässigmachen der Kommutationselemente (51), die entlang der Eingangsleitung (33) des ersten Kettenverstärkers (31) verteilt sind, und zum Sperrendmachen der Kommutationselemente (52), die entlang der Ausgangsleitung (37) des zweiten Kettenverstärkers (32) verteilt sind, wenn ein Mikrowellensignal vom Ein-/Ausgangsport (43) zum Ausgangsport (45) passieren soll.

7. Aktiver Duplexer nach Anspruch 4 und 5 oder nach Anspruch 6, **dadurch gekennzeichnet, dass** die Kommutationselemente (51), die entlang der Eingangsleitung (33) des ersten Kettenverstärkers (31) verteilt sind, und die Kommutationselemente (52), die entlang der Ausgangsleitung (37) des zweiten Kettenverstärkers (32) verteilt sind, Feldeffekttransistoren mit Nullspannung zwischen ihrem Drain und ihrer Source sind.

8. Sende- und Empfangsmodul, **dadurch gekennzeichnet, dass** es einen gesteuerten aktiven Mikrowellen-Duplexer nach einem der vorherigen Ansprüche umfasst, wobei der Eingangsport (44) mit einem Sendepfad verbunden ist, wobei der Ein-/Ausgangsport (43) mit einer Antenne verbunden werden kann und der Ausgangsport (45) mit einem Empfangspfad verbunden ist.

9. Modul nach Anspruch 8, **dadurch gekennzeichnet, dass** der Sendepfad einen Leistungsverstärker umfasst, der stromab an einen Punkt angeschlossen ist, der mit Verarbeitungsmitteln verbunden werden kann, und der Empfangspfad einen rauscharmen Verstärker umfasst, der stromauf an einen Punkt angeschlossen ist, der mit den Verarbeitungsmitteln verbunden werden kann.
